# EUROPEAN PATENT APPLICATION

(11) **EP 0 622 473 A1**
(43) Date of publication of application: **02.11.1994**
(21) Application number: 94201073.7
(22) Date of filing: 19.04.1994
(51) Int. Cl.: C23C 16/26

(54) **Method for making a diamond coated structure**

(30) Priority: 29.04.1993 US 54763
(71) Applicant: NORTON COMPANY, Worcester, MA 01615-0008 (US)
(72) Inventor: Bigelow, Louis K., Boylston, MA 01545 (US)
(74) Representative: Richebourg, Michel François

(57) **Abstract**

A method is disclosed of forming a diamond coated optical window or dome, comprising the following steps: providing a mandrel having a concave surface; depositing a diamond film on the concave surface by chemical vapor deposition; depositing an optically selective material on the diamond film; and removing the diamond film, with the optically selective material thereon, from the mandrel.

## Description

### FIELD OF THE INVENTION

This invention relates to a method of making a diamond coated structure, and more particularly, to a method for making a non-planar diamond coated optical window.

### BACKGROUND OF THE INVENTION

Diamond has properties which make it attractive for use as window material or coating. Among these properties are extreme hardness, thermal stability, inertness, and excellent transmissivity of certain radiation.

In recent years, a number of techniques have been developed for depositing synthetic diamond on surfaces of various shapes to obtain a diamond film or coating. These techniques include so-called chemical vapor deposition ("CVD") methods wherein, for example, a plasma of a hydrocarbon and hydrogen is used to deposit diamond film.

It is known that materials such as zinc sulfide or zinc selenide can be coated with diamond to obtain a rugged infrared (IR) window. However, zinc sulfide and zinc selenide are relatively reactive substances, and are attacked by reactive ions at the high temperatures used for diamond film deposition from the vapor phase. A protective interlayer, such as of silicon, may or may not sufficiently protect the reactive material long enough to apply the protective layer of diamond, but involves additional processing and is not ideal.

It is among the objects of the present invention to devise improved techniques for obtaining a diamond coating on a reactive material, such as for a non-planar optical window or dome.

### SUMMARY OF THE INVENTION

The present invention solves the problem of subjecting the optically selective substance to high temperature associated with diamond film deposition, and particularly the reactive ions associated with the deposition process, by fabricating the structure in an inverted order and with the diamond deposited first on a form or mandrel that is concave in shape for ultimate obtainment of a convex optical window or dome.

In accordance with an embodiment of the invention, a method is set forth of forming a diamond coated optical window or dome, comprising the following steps: providing a mandrel having a concave surface; depositing a diamond film on the concave surface by chemical vapor deposition; depositing an optically selective material on the diamond film; and removing the diamond film, with the optically selective material thereon, from the mandrel.

In the disclosed embodiment of invention, the step of depositing diamond by chemical vapor deposition is a relatively high temperature process, with temperature at the deposition surface of at least 850 degrees C, and the step of depositing the optically selective coating is a relatively lower temperature process with the temperature at the deposition surface of less than 800 degrees C. [Regardless of the temperatures employed, depositing the diamond layer first eliminates the problem of subjecting the optically selective coating to the reactive ions, such as hydrogen ions, associated with the deposition of diamond.]
In a disclosed embodiment hereof, the mandrel is formed of a material selected from the group consisting of molybdenum, tungsten, or graphite. An optional interlayer is deposited on the mandrel concave surface before the depositing of diamond film thereon. Also in this embodiment, the step of depositing an optically selective material comprises depositing a compound selected from the group consisting of zinc sulfide and zinc selenide. Other optically selective materials could alternatively be employed.

Further features and advantages of the invention will become more readily apparent from the following detailed description when taken in conjunction with the accompanying drawings.

### BRIEF DESCRIPTION OF THE DRAWINGS

Fig. 1 is an operational flow diagram illustrating an embodiment of a method in accordance with the invention.

Figures 2A through 2D illustrate the structure being fabricated at different stages of the procedure, and Fig. 2E illustrates the completed structure.

Fig. 3 illustrates a plasma jet deposition system of a type which can be utilized for depositing a diamond layer used in an embodiment of the invention.

### DETAILED DESCRIPTION

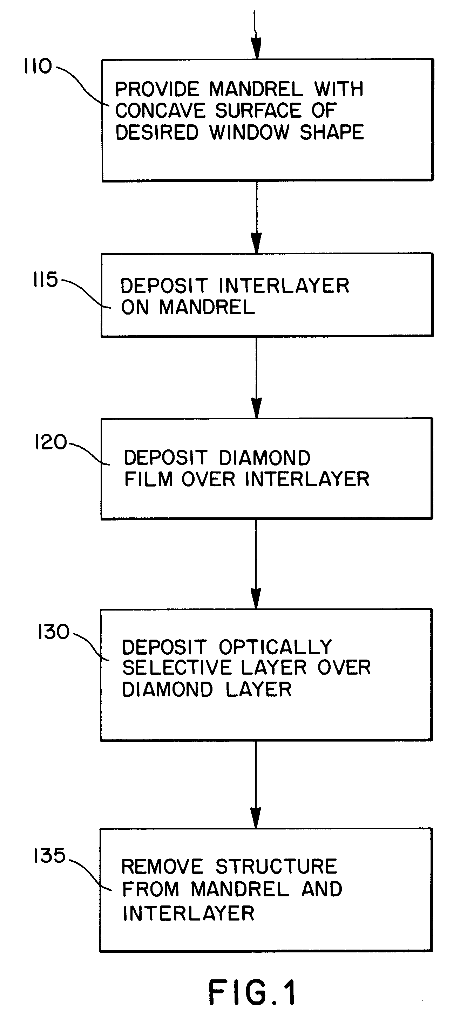

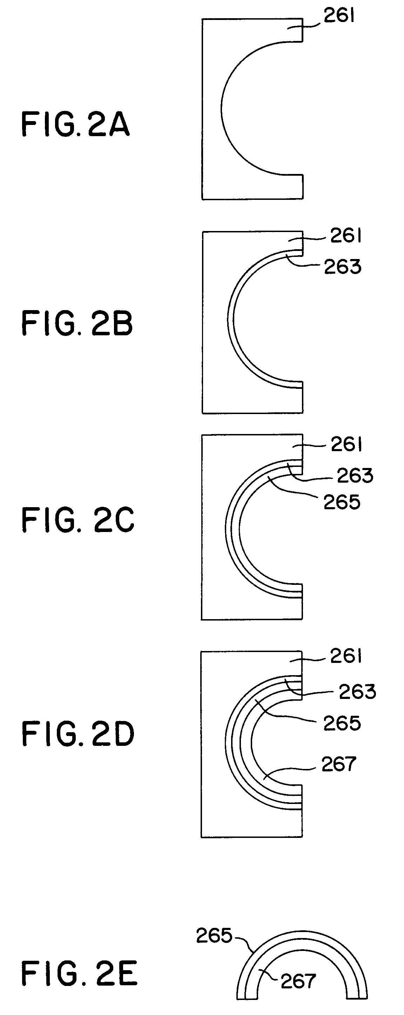

Referring to Fig. 1, there is shown an operational flow diagram of a method in accordance with an embodiment of the invention. The block 110 represents providing a mandrel or form (hereinafter generically referred to as a mandrel) having a concave surface of desired window shape. An example of such a mandrel or form is illustrated in Fig. 2A. Various materials can be utilized for the mandrel. For example, it can be formed of molybdenum, tungsten, or graphite. A metal mandrel may be formed, such as by machining, grinding and polishing, or by depositing a layer of the desired metal on an appropriately formed base. A graphite mandrel may be formed, for example, by machining, and has the advantage of being easily shaped to a desired curvature. The surface of the mandrel can be polished to a relatively smooth finish to facilitate obtainment of a smooth surface on the outer diamond window of the finished product. An example of a mandrel is illustrated at 261 in Fig. 2A, the illustrated mandrel having a concave spherical shape. It will be understood that other curved concave shapes can be utilized, examples being elliptical or parabolic.

The block 115 represents the depositing of an interlayer on the surface of the mandrel. Depending on the type of mandrel material used, an interlayer may optionally be provided to facilitate subsequent deposition of diamond and/or ultimate release or removal of diamond from the mandrel. For example, in the case of a molybdenum or tungsten mandrel, a thin layer of titanium nitride, for example of thickness 3 to 5 microns, may be applied to the surface of the mandrel, such as by physical vapor deposition (PVD). Reference can be made, for example, to copending U.S. Patent Application Serial No. 973,994, assigned to the same assignee as the present Application. Examples of other possible interlayers, such as when using a molybdenum mandrel, are titanium carbide, hafnium nitride, zirconium nitride, aluminum nitride, and aluminum oxide, as well as mixtures and compounds of these materials. When a graphite mandrel is used, a molybdenum interlayer can be employed. If necessary or desirable, a plurality of interlayers can be utilized. In Fig. 2B, there is shown the mandrel 261 with an interlayer 263 deposited thereon.

Referring again to Fig. 1, the block 120 represents the deposition of a diamond film, such as by chemical vapor deposition (CVD), using a plasma beam or a microwave plasma of a hydrocarbon and hydrogen. The thickness of the resultant polycrystalline diamond layer will depend on the application of the optical window being produced, and deposition time will be selected accordingly.

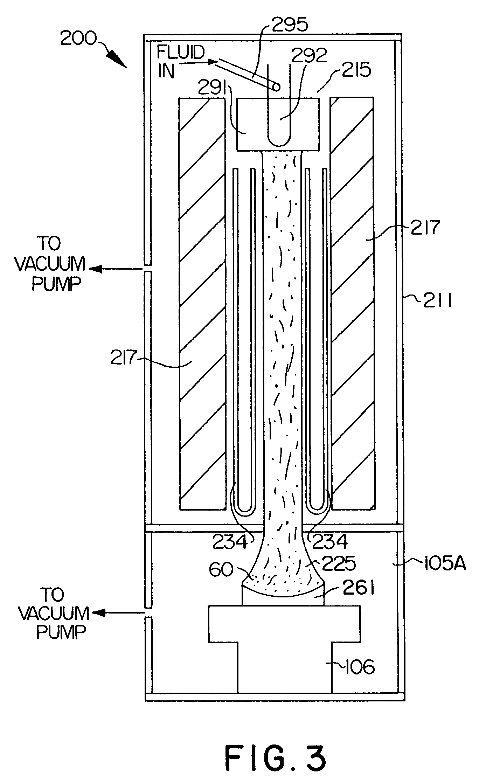

Fig. 3 shows a diagram of a plasma jet deposition system 200 of a type which can be utilized for depositing the diamond layer in an embodiment of the invention. The system 200 is contained within a vacuum housing 211 and includes an arc-forming section 215 which comprises a cylindrical anode 291, a rod-like cathode 292, and an injector 295 mounted adjacent the cathode so as to permit injected fluid to pass over the cathode 292. In the illustrated system the input fluid may be a mixture of hydrogen and methane. The anode 291 and cathode 292 are energized by a source of electric potential (not shown), for example a DC potential. Cylindrical magnets, designated by reference numeral 217, are utilized to control the plasma generated at the arc forming section. The magnets maintain the plasma within a narrow column until the plasma reaches the deposition region 60. Cooling coils 234, in which water or liquid nitrogen can be circulated, are located within the magnets and surround the focused plasma.

In operation, a mixture of hydrogen and methane is fed to the injector 295, and a plasma is obtained in front of the arc forming section and accelerated and focused toward the deposition region. The temperature and pressure at the plasma formation region are typically in the approximate ranges 1500-10,000 degrees C and 100-700 torr, respectively, and in the deposition region are in the approximate ranges 500-1100 degrees C and 0.1-200 torr, respectively. As is known in the art, synthetic polycrystalline diamond can be formed from the described plasma, as the carbon in the methane is selectively deposited as diamond, and graphite formation is suppressed by the hydrogen facilitating gas.

The bottom portion 105A of the chamber has a base 106 on which can be mounted the mandrel 261, with optional interlayer (not shown) on which the synthetic diamond is to be deposited. The base can include a temperature controller.

Fig. 2C illustrates the mandrel 261 with a polycrystalline diamond layer 265 deposited on interlayer 263.

After deposition of the diamond layer 263, an optional interlayer (not shown) can be applied. Next, the block 130 (Fig. 1) represents the deposition of an optically selective layer, which filters or transmits a particular range of optical wavelengths. In the illustrated embodiment hereof, the optically selective layer may be, for example, a layer of zinc sulfide or zinc selenide, these substances being commonly used in infrared optical windows or domes. The layer may be applied, for example, by CVD process, which is typically a relatively low temperature process implemented at less than 800 degrees C.

Fig. 2D illustrates the mandrel 261, interlayer 263, diamond layer 265, and optically selective layer 267, after deposition of the layer 267.

The deposited structure can then be removed from the mandrel, as represented by the block 135 of Fig. 1. If, for example, the mandrel was made of graphite, with a molybdenum interlayer, the graphite can be cut and ground away, and the molybdenum interlayer removed by etching. If, for example, the mandrel is formed of metal such as molybdenum or tungsten, the deposited structure can be removed by chemical dissolution, and surface finished. The resultant optically selective dome 267, with diamond coating 265 thereon, is illustrated in Fig. 2E.

In a further embodiment, the deposited diamond film can be removed from the mandrel, e.g. by using the above indicated techniques, before the deposition of the optically selective material on the concave surface of the diamond film.

## Claims

1. A method of forming a diamond coated optical window, comprising the steps of:
providing a mandrel having a concave surface;
depositing a diamond film on said concave surface by chemical vapor deposition;
depositing an optically selective material on said diamond film; and
removing said diamond film, with said optically selective material thereon, from said mandrel.

2. The method as defined by claim 1, wherein said step of depositing diamond film by chemical vapor deposition is a relatively high temperature process with temperature at the deposition surface of at least 850 degrees C, and said step of depositing said optically selective material is a relatively low temperature process with temperature at the deposition surface of less than 800 degrees C.

3. The method as defined by claim 1, further comprising the step of depositing an interlayer on said concave surface before the depositing of a diamond film thereon.

4. The method as defined by claim 2, further comprising the step of depositing an interlayer on said concave surface before the depositing of a diamond film thereon.

5. The method as defined by claim 1, wherein said step of depositing an optically selective material comprises depositing a layer selected from the group consisting of zinc sulfide and zinc selenide.

6. The method as defined by claim 2, wherein said step of depositing an optically selective material comprises depositing a layer selected from the group consisting of zinc sulfide and zinc selenide.

7. The method as defined by claim 4, wherein said step of depositing an optically selective material comprises depositing a layer selected from the group consisting of zinc sulfide and zinc selenide.

8. The method as defined by claim 1, wherein said step of providing a mandrel comprises providing a mandrel formed of a material selected from the group consisting of molybdenum, tungsten, and graphite.

9. The method as defined by claim 2, wherein said step of providing a mandrel comprises providing a mandrel formed of a material selected from the group consisting of molybdenum, tungsten, and graphite.

10. The method as defined by claim 6, wherein said step of providing a mandrel comprises providing a mandrel formed of a material selected from the group consisting of molybdenum, tungsten, and graphite.

11. The method as defined by claim 3, wherein said step of providing a mandrel comprises providing a molybdenum mandrel, and wherein said step of depositing an interlayer comprises depositing an interlayer of titanium nitride.

12. The method as defined by claim 4, wherein said step of providing a mandrel comprises providing a molybdenum mandrel, and wherein said step of depositing an interlayer comprises depositing an interlayer of titanium nitride.

13. The method as defined by claim 3, wherein said step of providing a mandrel comprises providing a graphite mandrel, and wherein said step of depositing an interlayer comprises depositing an interlayer of molybdenum.

14. The method as defined by claim 4, wherein said step of providing a mandrel comprises providing a graphite mandrel, and wherein said step of depositing an interlayer comprises depositing an interlayer of molybdenum.

15. A method for making an optical dome for infrared radiation, comprising the steps of:
providing a mandrel having a concave surface;
depositing a diamond film on said concave surface by chemical vapor deposition using a relatively high temperature process with temperature at the deposition surface of at least 850 degrees C;
depositing zinc sulfide or zinc selenide on said diamond film using a relatively low temperature process with temperature at the deposition surface of less than 800 degrees C; and
removing said diamond film, with said zinc sulfide or zinc selenide thereon, from said mandrel.

16. The method as defined by claim 15, further comprising the step of depositing an interlayer on said concave surface before the depositing of a diamond film thereon.

17. The method as defined by claim 15, wherein said step of providing a mandrel comprises providing a mandrel formed of a material selected from the group consisting of molybdenum, tungsten, and graphite.

18. The method as defined by claim 16, wherein said step of providing a mandrel comprises providing a mandrel formed of a material selected from the group consisting of molybdenum, tungsten, and graphite.

19. The method as defined by claim 16, wherein said step of providing a mandrel comprises providing a molybdenum mandrel, and wherein said step of depositing an interlayer comprises depositing an interlayer of titanium nitride.

20. The method as defined by claim 16, wherein said step of providing a mandrel comprises providing a graphite mandrel, and wherein said step of depositing an interlayer comprises depositing an interlayer of molybdenum.

21. A method of forming a diamond coated optical window, comprising the steps of:
providing a mandrel having a concave surface;
depositing a diamond film on said concave surface by chemical vapor deposition;
removing the diamond film from the mandrel; and
depositing an optically selective material on the concave surface of said diamond film.

22. The method as defined by claim 21, wherein said step of depositing diamond film by chemical vapor deposition is a relatively high temperature process with temperature at the deposition surface of at least 850 degrees C, and said step of depositing said optically selective material is a relatively low temperature process with temperature at the deposition surface of less than 800 degrees C.
